# EUROPEAN PATENT SPECIFICATION

(11) **EP 2 338 009 B1**
(45) Date of publication and mention of the grant of the patent: **16.08.2017**
(21) Application number: 09822280.5
(22) Date of filing: 21.10.2009
(51) Int. Cl.: F24J 2/14, F24J 2/52, F24J 2/46, F24J 2/07, F24J 2/24, F24J 2/54, H01L 31/052, H01L 31/054

(54) **MOUNTING A RECEIVER IN A SOLAR ENERGY TROUGH**
MONTAGE EINES EMPFÄNGERS IN EINEM SONNENENERGIERAHMEN
MONTAGE D'UN RÉCEPTEUR DANS UN SYSTÈME À ÉNERGIE SOLAIRE

(30) Priority: 22.10.2008 SE 0802260
(43) Date of publication of application: 29.06.2011
(73) Proprietor: Absolicon Solar Collector AB, 871 33 Härnösand (SE)
(72) Inventor: NILSSON, Johan, S-871 33 Härnösand (SE)
(86) International application number: PCT/SE2009/051202
(87) International publication number: WO 2010/047656

(56) References cited:
- EP-A1- 1 801 517
- EP-A1- 1 801 517
- DE-A1- 2 738 602
- DE-U1- 20 220 390
- US-A- 4 326 773
- US-A- 4 355 630
- US-A1- 2008 083 405

## Description

### BACKGROUND ART

A rapid development is currently occurring in the field of solar energy. The technological development encompasses a multitude of different areas within the field of solar energy, from simple flat thermal solar collectors for water heating in swimming pools to advanced solar cell systems that by concentrating the sunlight by a thousand times converts sunlight to electricity with an efficiency of over 30%.

In concentrating solar energy systems sunlight is focussed using different optical systems such as reflectors or lenses onto a receiver, in which the concentrated sunlight is converted into other forms of energy, for instance electricity or heat.

One type of concentrating solar energy systems is parabolic troughs where the sunlight is concentrated into a longitudinal line. An example is the 84 m long and 6 m wide Euclides at ITER on Tenerife, that converts sunlight to electricity, and the "Parabolrinnen" by the German company Solar Millennium AG, that heats oil to 400 0C.

A concentrating solar energy system comprises a number of components, optical components for concentrating the light, components for continuously tracking the sun, receivers for receiving the concentrated solar radiation, and different kinds of ancillary equipment, such as turbines or hot water heaters.

To date, the receivers have commonly been integrated with the reflector systems and may only be removed with great difficulty. US2008/0083405 discloses an example of such a solar energy system. In particular, for systems over a few metres the receiver has not been possible to remove in its entirety, except by disassembling the receiver into shorter units. The result is that the receiver is difficult to receive and that cleaning and service is complicated.

A movable receiver has been demonstrated in EP 1801517. EP 1801517 discloses a movable receiver upon which the preamble of appending claim 1 is based. The receiver pipe is supported by a receiver holder post terminating at the top in a Y-shaped cradle, equipped with rollers or sliders on which the receiver can move. The purpose is to make it possible to handle thermal expansion of a receiver tube in a solar thermal parabolic trough. However, the sliders direct contact with the pipe may damage the sensitive coating Hence there is a need to provide an improved and flexible method of assembling receivers in solar energy systems in order to overcome the above problems.

### DISCLOSURE OF INVENTION

The purpose of this invention is to achieve an improved and flexible method of assembling receivers in solar energy systems.

In the design according to the invention the receiver can by supplied and removed in a very simple way without requiring disassembly. This leads to a number of positive, surprising effects for the solar energy system:
* The receiver can easily be replaced when better technology is available. For receivers with solar cells the technology is expected to develop quickly towards an ever increasing efficiency.
* Cleaning or service, which is usually lengthy because it is done with the receiver in place in the solar energy system, can instead be performed with the entire receiver removed and transferred to a suitable site.
* The entire solar energy plant can be assembled in situ without a receiver. The receiver can then be assembled in a simple final step before commissioning. This is favourable as the time from start of construction to commissioning can be long and the receiver is both expensive and sensitive.

The invention is intended for parabolic troughs but may also be implemented on other types of optics for concentrating solar energy systems.

A parabolic trough is defined as a trough substantially shaped as a truncated two-dimensional paraboloid extended into a semi-cylindrical pipe.

The invention relates to a solar energy system comprising optical components with a linear focal point and at least one receiver, wherein the solar energy system comprises a device assembling and disassembling the receiver. The receiver is arranged slidable along a longitudinal rail, which enables the receiver to be slid into and moved to a desired position in the solar energy system, or be disassembled respectively, in its entirety or in parts.

One or more rails are arranged on the surface of the reflector or on a possible glass covering enclosing the reflector, along which the receiver can travel. This may be achieved by attaching the reflector to one or more slides with sliding surfaces or wheels that travel easily along the rail.

This design allows the receiver to be assembled to a desired length remote from the trough and then be mounted in the trough by sliding it in from the short end of the parabolic trough. Conventionally, the receiver is mounted from the front, at right angles to the reflector, in short lengths using fixed attachments.

### BRIEF DESCRIPTION OF DRAWINGS

- Fig.1: shows a perspective view of a solar energy system in the form of a parabolic trough on legs in perspective;
- Fig.2: shows a cross-section of a trough with a receiver, rail and slide;
- Fig.3: shows a perspective view of the rail in Fig.2;
- Fig.4: shows a perspective view of the slide in Fig.2;
- Fig.5: shows a perspective view of a portion of the receiver in Fig.2;
- Fig.6a: shows the receiver partially assembled with the direction of assembly indicated with an arrow;
- Fig.6b: shows the receiver mounted in place in the trough.

### DETAILED DESCRIPTION OF THE INVENTION

The present invention will now be described with reference to the attached drawing figures, which are intended for illustrative purposes only.

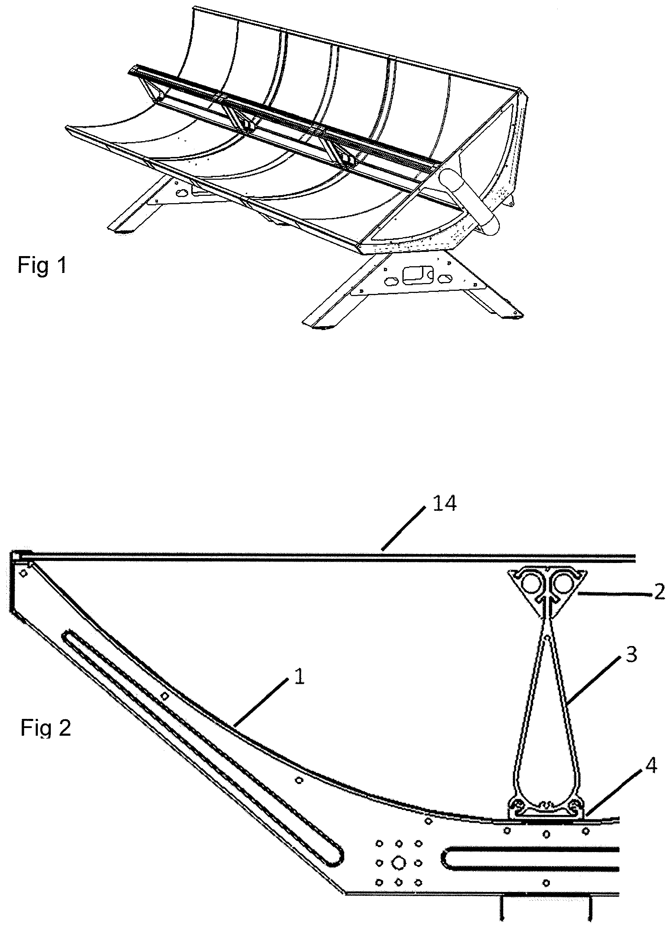

A solar energy system of the parabolic trough type (Fig.1) has been equipped with this device in order to simplify the assembly of a receiver. The trough may be approximately one metre wide and five metres long.

At the rear end of the trough there are two linear adjusting devices (not shown in the figure) which are used for rotating the trough towards the sun so that the receiver is positioned in focus. The front of the trough is in some embodiments covered by a transparent covering sheet (14) made from for instance glass or transparent plastic that enclosed the reflector in order to protect the reflector sheet or to increase the stiffness of the trough.

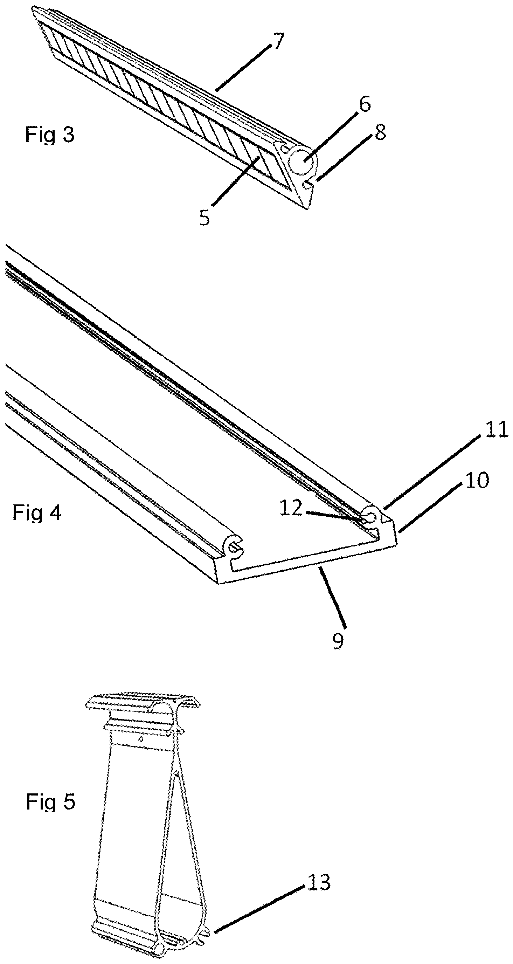

Fig.2 shows a cross-section through the trough with the receiver assembled. A rail or track (4) is arranged on the surface of the reflector, in which rail one or more slides (3) are arranged. A receiver (2) is arranged on the side/slides. Figs.3-5 show a portion of the receiver, the slide and the rail.

Fig.2 shows a trough made from a reflective metal sheet (1). The metal sheet of the reflector can be a 1 mm steel sheet with a coating of, for instance, a silver film. The reflector metal sheet (1) focuses the light onto a receiver (2), also called an absorber, the surface of which is provided with solar cells (5).

The receiver shown in Fig.2 has a triangular cross-section, which gives a good absorption of the rays of light reflected by the surface of the reflector towards the solar cells of the receiver. The receiver may also have other cross-sections which enable absorption of reflected rays of light from the surface of the reflector

The receiver can also comprise two halves (7) having longitudinal slots (8) in which the slide (3) is mounted. Each half is also provided with through holes or channels (6) for coolant. If the receiver is given a triangular cross-section, then, suitably, so are the halves. The halves of the receiver can be manufactured by extrusion, which gives an effective manufacturing process. A suitable material is extruded aluminium, gives a high strength and low weight. An alternative to aluminium is a plastic material.

An extended rail (4) is arranged at the bottom of the trough, which rail comprises a first section (9) intended to be attached to the trough, hereafter termed the attachment part, and a second section (10) on which the slide is slidable. The second section (10), hereafter termed the sliding means, can comprise one or more sliding elements (11), shaped as a device extending from the attachment part, the outer portion of which is shaped as a head (12). In Fig.2 a rail is shown having a sliding element on either side of the attachment part (9).

The rail can be extruded, and is suitably made from aluminium, for high strength and low weight. Alternatively, the rail can be made from a plastic material. In order to facilitate transport and handling the rail can comprise a number of rail portions which are assembled end to end in the reflector trough. Each sliding element (10) may in this case be provided with a hole through its centre in the outer portion (12), in which hole a pin can be mounted in order to facilitate exact positioning of two sections during joining in their longitudinal direction.

The slide (3) can comprise an extended continuous profile running along substantially the entire length of the receiver, or a number of discrete elements placed distributed along the length of the receiver. One end of the slide is provided with means (13) for attaching the receiver (2). These may comprise extending portions adapted to engage in slots (8) in the receiver, enabling a simple mounting of the slide onto the receiver. The cross-section of the slide can have a wing profile (see Fig.2) so that it is wider at the end that is closer to the rail (4) and the bottom of the trough in the assembled position, which gives a strong construction. The portion of the slide located between the receiver and the rail (4) is preferably hollow, giving a reduced weight. The slide can be manufactured from hydro-cut or extruded aluminium.

At the end of the slide arranged to slide on the rail (4) there is provided at least one receiving means (13) shaped so that it can engage with the sliding elements of the rail (4). The receiving means (13) can be shaped so that its cross-section encircles the head (12) of the sliding element. Plastic inserts can be inserted in the receiving means to reduce friction between the receiving means and the sliding element. The slide can suitably be provided with at least two receiving means (13) for increased stability. In the embodiment shown in Fig.2 the slide comprises two receiving means (13) encircling the heads (12) of the sliding elements so that the receiving means and the sliding element are locked against relative motion in all directions except in the longitudinal direction of the rail (the sliding direction).

Alternatively, the sliding element can be arranged on the slide and the receiving means on the rail.

The rail and the associated slide can alternatively be arranged in different ways. For instance, the connection between the slide and the rail can be achieved by means of wheels, sliding bearings or roller bearings in different combinations.

There are also other alternatives for the position of the rail in the trough. The rail may, for instance, be attached below a possible covering sheet (14); at the edges of the trough, or at the bottom of the trough or in combinations thereof. The rail may for instance be mounted both above the receiver attached to the covering sheet or below the receiver attached to the bottom of the trough. In this case the receiver is mounted between the rails which are connected by the slides. Connecting the covering sheet and the bottom of the trough in this way will increase the ability of the covering sheet to resist forces from outside. Assembling the rail at the bottom of the trough only will avoid the risk of the slide or the rail shading the reflector from incident sunlight.

The rail can be mounted by, for instance, glue, tape, rivets, screws, bolts or be attached by placing the rail in slots or lugs arranged in the trough. If the rail is glued to the reflector metal sheet with reinforcing through bolts at the ends thereof, little damage is done to the metal sheet and assembly will be fast and simple.

Alternatively, the rail can be an integrated part of some other function in the reflector trough, for instance a bent section in the reflector metal sheet, a longitudinal edge or a slit e.g. between the covering sheet and the reflector metal sheet.

The receiver in the system shown in Fig.2 is intended for combined electricity and heat generation where solar cells (5) for concentrated light have been laminated onto the receiver. A coolant is pumped through channels (6) inside the receiver, which coolant cools the solar cells and extracts heat from the system that can be used for e.g. hot water.

The receiver may have different embodiments and can be used for different types of energy conversion, such as generation of electricity only using solar cells (possibly cooled by air); only for extraction of heat using e.g. vacuum tubes or for chemical processes, such as hydrogen production using a receiver containing a catalyst. In all embodiments the receiver has a surface which can absorb light and convert it to one or more other forms of energy.

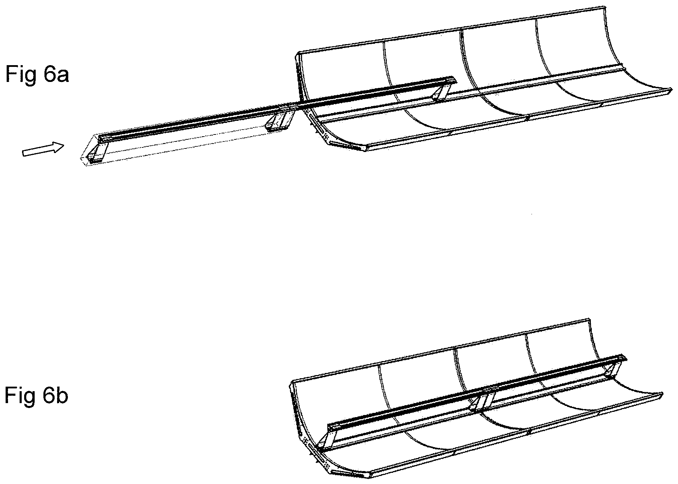

Hence, it is possible to mount the received entirely outside the trough after which it is added to the system by sliding it onto the rail. Alternatively it may be assembled piece by piece outside the trough and successively be slid into the trough. Fig.6a and 6b shows how the receiver is mounted in the trough by displacing it onto the rail.

When the receiver is to be removed it is pulled out in reverse order.

## Claims

1. A solar energy system comprising linearly focussing optical components and at least on receiver, **characterized in in that** it comprises a device for assembling and disassembling the receiver, wherein the receiver (2) is slidably arranged on a longitudinal rail (4), and wherein the receiver is arranged to travel on the rail by means of at least one slide connected to the rail by means of sliding surfaces or wheels, which enables the receiver in its entirety, or in parts to be slid into and moved to a desired position in the solar energy system, or disassembled, respectively.

2. A solar energy system according to claim 1, wherein the solar energy system comprises an extended parabolic reflector trough with a linear focus, where the rail is arranged in the longitudinal direction of the trough and the receiver (2) is introduced from the short end.

3. A solar energy system according to claim 2, wherein the rail is arranged at the bottom of the trough or at the underside of a covering sheet (14).

4. A method for assembling or disassembling receivers in a concentrating solar energy system according to one of the claims 1-3 comprising linearly focussing optical components and at least on receiver, where, during assembly, the receiver is slid onto a rail arranged in the solar energy system and is moved along the rail into a desired position in the solar energy system, and during disassembly is pulled out along the rail.

5. Method according to claim 4, wherein the receiver is attached to a slide before it is moved into the solar energy system, and that the slide is slid onto the rail and is connected to the rail by sliding surfaces or wheels.

6. Method according to one of the claims 4 or 5, wherein the solar energy system comprises an extended parabolic trough, where the rail runs in the longitudinal direction of the trough and where the receiver is introduced the short end of the trough.

7. Method according to one of the claims 4-6, wherein the receiver is fixed in the trough when it has been moved to a desired position.

8. A method for generating solar heat and/or electricity using a solar energy system according to any one of the claims 1-3.

## Patentansprüche

1. Sonnenenergiesystem, umfassend linear fokussierende optische Komponenten und mindestens einen Empfänger, **dadurch gekennzeichnet, dass** es eine Vorrichtung zum Montieren und Demontieren des Empfängers umfasst, wobei der Empfänger (2) verschiebbar auf einer Längsschiene (4) angeordnet ist und wobei der Empfänger so angeordnet ist, dass er sich auf der Schiene mittels mindestens eines Schiebers bewegt, der über Gleitflächen oder Räder mit der Schiene verbunden ist, wodurch der Empfänger als Ganzes oder teilweise in eine gewünschte Position in dem Sonnenenergiesystem geschoben und bewegt beziehungsweise demontiert werden kann.

2. Sonnenenergiesystem nach Anspruch 1, wobei das Sonnenenergiesystem eine längs ausgedehnte Parabolreflektorrinne mit einem Linienfokus umfasst, wobei die Schiene in der Längsrichtung der Rinne angeordnet ist und der Empfänger (2) vom kurzen Ende aus eingeschoben wird.

3. Sonnenenergiesystem nach Anspruch 2, wobei die Schiene am Boden der Rinne oder an der Unterseite einer Abdeckplatte (14) angeordnet ist.

4. Verfahren zum Montieren oder Demontieren von Empfängern in einem konzentrierenden Sonnenenergiesystem nach einem der Ansprüche 1 bis 3, das linear fokussierende optische Komponenten und mindestens einen Empfänger umfasst, wobei der Empfänger während der Montage auf eine im Sonnenenergiesystem angeordnete Schiene geschoben und die Schiene entlang in eine gewünschte Position im Sonnenenergiesystem bewegt wird und während der Demontage die Schiene entlang herausgezogen wird.

5. Verfahren nach Anspruch 4, wobei der Empfänger an einem Schieber angebracht wird, bevor er in das Sonnenenergiesystem hinein bewegt wird, und dass der Schieber auf die Schiene geschoben wird und mit der Schiene über Gleitflächen oder Räder verbunden wird.

6. Verfahren nach einem der Ansprüche 4 oder 5, wobei das Sonnenenergiesystem eine längs ausgedehnte Parabolrinne umfasst, wobei die Schiene in der Längsrichtung der Rinne verläuft und wobei der Empfänger vom kurzen Ende der Rinne aus eingeschoben wird.

7. Verfahren nach einem der Ansprüche 4 bis 6, wobei der Empfänger in der Rinne befestigt wird, wenn er in eine gewünschte Position bewegt wurde.

8. Verfahren zum Erzeugen von Solarwärme und/oder -strom unter Verwendung eines Sonnenenergiesystems nach einem der Ansprüche 1 bis 3.

## Revendications

1. Système à énergie solaire comprenant des composants optiques à focalisation linéaire et au moins un récepteur, **caractérisé en ce qu'**il comprend un dispositif pour le montage et le démontage du récepteur, le récepteur (2) étant agencé de manière coulissante sur un rail longitudinal (4), et le récepteur étant agencé pour se déplacer sur le rail au moyen d'au moins un coulisseau relié au rail au moyen de surfaces de glissement ou de roues, ce qui permet au récepteur dans sa totalité ou en partie d'être glissé et déplacé dans une position souhaitée dans le système à énergie solaire, ou respectivement démonté.

2. Système à énergie solaire selon la revendication 1, dans lequel le système à énergie solaire comprend un miroir réflecteur cylindro-parabolique long à focalisation linéaire, le rail étant agencé dans la direction longitudinale du miroir et le récepteur (2) étant introduit par l'extrémité courte.

3. Système à énergie solaire selon la revendication 2, dans lequel le rail est agencé au fond du miroir ou sur la face inférieure d'une plaque de recouvrement (14).

4. Procédé de montage ou démontage de récepteurs dans un système à énergie solaire concentrateur selon l'une des revendications 1 à 3 comprenant des composants optiques à focalisation linéaire et au moins un récepteur, dans lequel, pendant le montage, le récepteur est glissé sur un rail agencé dans le système à énergie solaire et est déplacé le long du rail dans une position souhaitée dans le système à énergie solaire, et, pendant le démontage, est extrait le long du rail.

5. Procédé selon la revendication 4, dans lequel le récepteur est fixé à un coulisseau avant d'être déplacé dans le système à énergie solaire, et en ce que le coulisseau est glissé sur le rail et est relié au rail par des surfaces de glissement ou des roues.

6. Procédé selon l'une des revendications 4 ou 5, dans lequel le système à énergie solaire comprend un miroir cylindro-parabolique long, dans lequel le rail s'étend dans la direction longitudinale du miroir et dans lequel le récepteur est introduit par l'extrémité courte du miroir.

7. Procédé selon l'une des revendications 4 à 6, dans lequel le récepteur est fixé dans le miroir quand il a été déplacé dans une position souhaitée.

8. Procédé de génération de chaleur et/ou d'électricité solaire au moyen d'un système à énergie solaire selon l'une quelconque des revendications 1 à 3.
